## Europäisches Patentamt
## European Patent Office
## Office européen des brevets

(11) Veröffentlichungsnummer: **0 023 696**
**B1**

(12) **EUROPÄISCHE PATENTSCHRIFT**

(45) Veröffentlichungstag der Patentschrift:
**25.04.84**

(51) Int. Cl.³: **G 01 R 31/08,** G 01 R 17/10

(21) Anmeldenummer: **80104438.9**

(22) Anmeldetag: **28.07.80**

(54) **Ortungsgerät für Isolationsfehler.**

(30) Priorität: **02.08.79 DE 2931466**

(43) Veröffentlichungstag der Anmeldung:
**11.02.81 Patentblatt 81/6**

(45) Bekanntmachung des Hinweises auf die Patenterteilung:
**25.04.84 Patentblatt 84/17**

(84) Benannte Vertragsstaaten:
**BE FR GB NL**

(56) Entgegenhaltungen:
**DE - C - 898 782**

(73) Patentinhaber: **SIEMENS AKTIENGESELLSCHAFT,
Berlin und München Wittelsbacherplatz 2,
D-8000 München 2 (DE)**

(72) Erfinder: **Vellage, Karl-Heinz, Schobertweg 341/2,
D-8520 Erlangen (DE)**
Erfinder: **Friesleben, Klaus, Am Schellenberg 13,
D-8550 Forchheim (DE)**

EP 0 023 696 B1

### Ortungsgerät für Isolationsfehler

Die Erfindung betrifft ein Ortungsgerät für Isolationsfehler eines mehrere Flugplatzfeuer und dazwischen liegende Kabelabschnitte enthaltenden Serienstromkreises, wobei die Kabelabschnitte jeweils aus einem Innenleiter und einem diesen konzentrisch umgebenden Schirm bestehen.

Um den mit der Beseitigung eines Isolationsfehlers verbundenen Aufwand so gering wie möglich zu halten, sollte der Fehler bei der Bestimmung des Ortes des Isolationsfehlers unter einem Prozent liegen; dem entsprechen 100 m bei einer Länge des Serienstromkreises von 10 km. Dem Erreichen einer solchen Genauigkeit stehen jedoch besondere Schwierigkeiten entgegen: Wegen der Reihenschaltung der einzelnen Flugplatzfeuer ist der Serienstromkreis inhomogen, wobei noch die Kapazitäten der einzelnen Kabelabschnitte sich abhängig von Temperatur und Feuchtigkeit bis zu 50% verändern können. Zudem verfälschen diese Kapazitäten das Meßergebnis, wenn man mit Wechselstrom arbeitet. Gleichstrom scheidet andererseits aus, da die Lampen über Stromwandler in Reihe geschaltet sind. Aus diesen Gründen sind bekannte, auf einer Kapazitätsmessung beruhende Brückenanordnungen (DE-C-898 782) hier nicht brauchbar.

Der Erfindung liegt die Aufgabe zugrunde, ein Ortungsgerät für Serienstromkreise der eingangs genannten Art anzugehen, mit dem sich die gewünschte Meßgenauigkeit erreichen läßt.

Die erfindungsgemäße Lösung dieser Aufgabe ist gekennzeichnet durch zwei Hauptklemmen zum Verbinden des von seiner Speisequelle abgetrennten Serienstromkreises mit einer Wechselspannungsquelle, durch einen der Wechselspannungsquelle parallelgeschalteten Vergleichszweig einer Meßbrücke, durch einen ein Abgleichinstrument enthaltenden Abgleichzweig zwischen einem Abgriff des Vergleichszweiges und einer Hilfsklemme zum Anschluß des Schirmes der Kabelabschnitte, durch einen Spannungsmesser zwischen einer der Hauptklemmen und dem Abgriff des Vergleichszweiges, und durch einen Abgleichkondensator mit einstellbarer Kapazität, der einerseits mit der Hilfsklemme verbunden und andererseits mittels eines Umschalters an jede der beiden Klemmen der Wechselspannungsquelle schaltbar ist.

Mit einem solchen Ortungsgerät läßt sich die kapazitive Komponente des Serienstromkreises getrennt von der ohmschen abgleichen. Bei abgeglichener Brücke verhalten sich dann die kapazitiven Impedanzen des Serienstromkreises zu beiden Seiten des Isolationsfehlers wie die entsprechenden ohmschen Widerstände des Vergleichszweiges bzw. Serienstromkreises. Die Meßbrücke liefert somit das nur durch die ohmschen Widerstände bestimmte Potential des Kabelschirmes und damit des Ortes des Isolationsfehlers bezogen auf Anfang oder Ende des Serienstromkreises, wobei der Meßfehler nur von der Anzeigegenauigkeit der Instrumente abhängig ist.

Aufgrund der Anzeige des Spannungsmessers des Ortungsgerätes läßt sich der Fehlerort grafisch mit Hilfe eines Potentialdiagrammes — Potentialverlauf abhängig vom Ort — ermitteln. Hierbei muß allerdings die von der Wechselspannungsquelle gelieferte Spannung bekannt sein. Zu deren Ermittlung ist es zweckmäßig, einen zusätzlichen Spannungsmesser zu verwenden und somit zwei Spannungsmesser jeweils zwischen den Hauptklemmen und dem Abgriff des Vergleichszweiges der Meßbrücke anzuordnen.

Gemäß einer besonders zweckmäßigen Weiterbildung der Erfindung ist zwischen jeder der Hauptklemmen und dem zugeordneten Ende des Vergleichszweiges der Meßbrücke ein Eichwiderstand bzw. ein Vergleichsflugplatzfeuer mit bekannter Ersatzimpedanz angeordnet, deren Spannungsabfall mit Hilfe der erwähnten Spannungsmesser mittels einer Umschalteinrichtung meßbar sind. Mit diesen Spannungen läßt sich dann der Fehlerort berechnen.

Die Wechselspannungsquelle liefert vorzugsweise eine einstellbare Spannung: Damit ist einerseits eine Anpassung an Serienstromkreise mit sehr unterschiedlicher Zahl von Flugplatzfeuern und ferner eine gezielte Herabsetzung der Meßspannung möglich. Letzteres ist zweckmäßig, da der stromabhängige Widerstand der Lampen mit der Betriebsspannung sinkt, was widerum eine höhere Meßgenauigkeit bei der Ortung zur Folge hat.

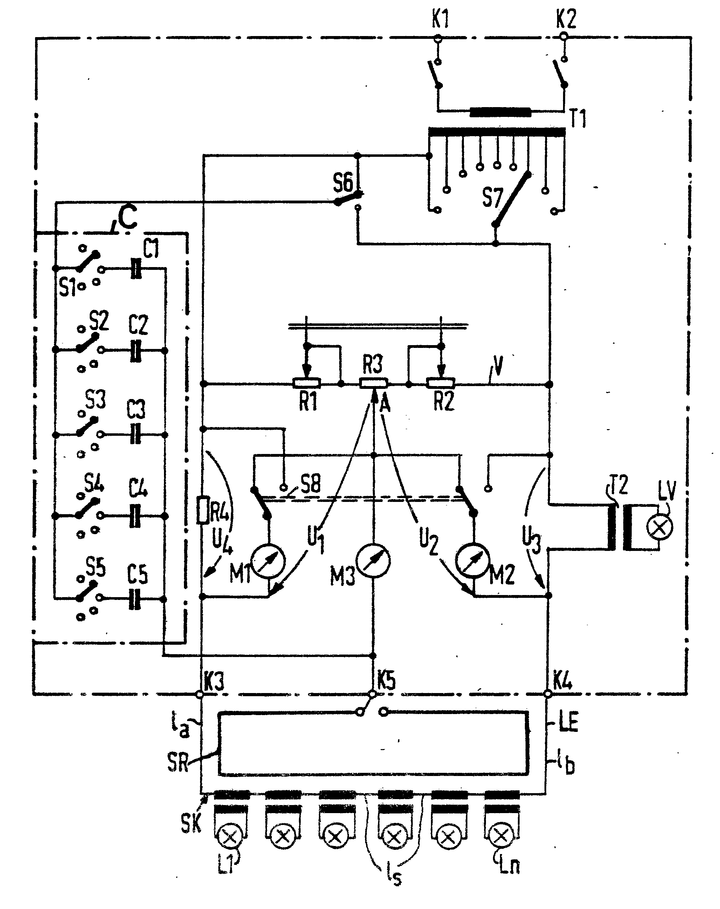

Ein Ausführungsbeispiel der Erfindung wird anhand der Figur erläutert:

Der zu untersuchende Serienstromkreis ist mit SK bezeichnet und enthält zur Veranschaulichung nur sechs Flugplatzfeuer L1 bis Ln, die über jeweils zugeordnete Transformatoren (Stromwandler) gespeist sind; praktisch liegen bis zu hundert Flugplatzfeuer in Reihe. Die Primärwicklungen dieser Transformatoren sind über Kabelabschnitte gleicher Länge $l_s$ in Reihe geschaltet und insgesamt über Kabelabschnitte mit der Länge $l_a$ bzw. $l_b$ an die Hauptklemmen K3 und K4 des Ortungsgerätes angeschlossen. Sämtliche Kabelabschnitte bestehen aus einem Leiter LE, der konzentrisch von einem Schirm SR umgeben ist; die Schirme der einzelnen Kabelabschnitte sind miteinander leitend verbunden und an die Hilfsklemme K5 des Ortungsgerätes angeschlossen.

Das Ortungsgerät bildet mit dem Serienkreis SK eine Meßbrücke, deren Vergleichszweig V, bestehend aus den Widerständen R1 bis R3, über einen Transformator T1 und die Klemmen K1, K2 an eine — nicht dargestellte — Wechselspannungsquelle angeschlossen ist. Die Größe der an die Meßbrücke gelangenden Spannung ist dabei mit Hilfe eines Stufenschalters S7 einstellbar. Die Widerstände R1 und R2 des Vergleichszweiges V sind mit gegenläufig verschiebbaren, gemeinsam zu bedienenden Abgriffen für eine Grobeinstellung versehen. Der Widerstand R3 weist einen

2

verstellbaren Abgriff A auf, der über das Abgleichinstrument M3 mit der Hilfsklemme K5 verbunden ist. Zwischen der Hauptklemme K3 und dem einen Ende des Vergleichszweiges V liegt ein Eichwiderstand R4 und zwischen der anderen Hauptklemme K4 und dem entgegengesetzten Ende des Vergleichszweiges ein Vergleichstransformator T2, an dessen Sekundärwicklung ein Vergleichsflugplatzfeuer LV angeschlossen ist; Transformator T2 und Vergleichsflugplatzfeuer LV sind identisch mit den entsprechenden Elementen des zu messenden Serienstromkreises.

Die Klemme K5 ist schließlich über eine Kondensatorbatterie C mit einstellbarer Kapazität mit einem der beiden Enden des Vergleichskreises V verbunden. Die Kondensatorbatterie C weist fünf über Schalter S1 bis S5 einstellbare Kondensatordekaden C1 bis C5 mit den Stufen 0,01 μF, 0,1 μF, 1 μF, 10 μF und 20 μF auf.

Die Spannungsmesser M1 und M2 sind zwischen den Hauptklemmen K3, K4 einerseits und dem Abgriff A des Vergleichszweiges V andererseits angeschlossen und mittels eines Umschalters S8 dem Eichwiderstand R4 bzw. dem Transformator T2 parallel schaltbar, um den Spannungsabfall $U_4$ bzw. $U_3$ an diesen Bauelementen bei abgeglichener Brücke bestimmen und daraus die Ersatzimpedanz des belasteten Transformators T2 berechnen zu können.

Zum Abgleich der Meßbrücke werden die Kondensatoren C1 bis C5 und die Einstellung des Vergleichszweiges V abwechselnd solange verändert, bis das Abgleichsinstrument M3 keinen Ausschlag mehr zeigt. Die Kapazitäten zu beiden Seiten des Isolationsfehlers verhalten sich dann umgekehrt wie die entsprechenden Teilwiderstände des Vergleichszweiges, so daß das gemessene Potential des Serienkreises SK an der Stelle des Erdschlusses von den Blindwiderständen nicht beeinflußt ist. Der Fehlerort läßt sich somit durch die von den Spannungsmessern M1 und M2 angezeigten Spannungen $U_1$ bzw. $U_2$ entweder über ein Potentialdiagramm oder nach den folgenden Formeln berechnen:

Formel (1) gibt dabei den Abstand $l_f$ des Isolationsfehlers vom Beginn bzw. Ende des Serienstromkreises an für den Fall, daß der Isolationsfehler vor dem ersten bzw. hinter dem letzten Flugplatzfeuer liegt (Bedingung $y < 1$):

$$l_f = l_{a,b} \cdot y \tag{1}$$

y ist dabei gegeben durch Formel (2)

$$y = \frac{U_1}{U_1 + U_2} \ \frac{R_a + R_b + R_L' \cdot n + R_s (n-1)}{R_a} \tag{2}$$

dabei ist $R_a$ der ohmsche Widerstand des Kabelabschnittes mit der Länge $l_a$ bis zum ersten Feuer L1, $R_b$ der ohmsche Widerstand des Kabelabschnittes der Länge $l_b$ nach dem letzten Feuer Ln, $R_s$ der Widerstand der als gleichlang (Länge $l_s$) angenommenen Kabelabschnitte zwischen je zwei Feuern und n die Zahl der im Serienstromkreis liegenden Feuer.

Ob in diesen Formeln $l_a$ oder $l_b$ in Betracht kommen, hängt davon ab, welchem Kabelabschnitt der Abgriff A näher steht, bzw. welche Stellung der Schalter S6 hat.

Die Ersatzimpedanz des Vergleichsflugplatzfeuers LV bestimmt sich nach Formel (3):

$$R_L' = \frac{U_3}{U_4} \ R_4 \tag{3}$$

wobei $R_4$ der Eichwiderstand, $U_4$ die an ihm gemessene Spannung und $U_3$ die an dem Vergleichsflugplatzfeuer gemessene Spannung bedeuten.

Sofern y gleich oder größer 1 ist, liegt der Isolationsfehler in einem der Kabelabschnitte zwischen je zwei aufeinanderfolgenden Feuern, und zwar zwischen den Feuern m und m+1, wobei man m aus der Beziehung (4) und K aus der Gleichung (5) aufgrund der Meßwerte erhält. $R_g$ ist dabei der nach Gleichung (6) zu berechnende Gleichstromwiderstand des Serienstromkreises:

$$m = K + x \tag{4}$$

$$K = \frac{\dfrac{U_1}{U_1 + U_2} \ (R_L' \cdot n + R_g) - R_a}{R_L' + R_s} \tag{5}$$

$$R_g = R_a + R_b + (n-1) \, R_s \tag{6}$$

x in Gleichung (4) wird so bestimmt, daß K+x die nächstgrößere ganze Zahl m ergibt. Der Abstand s des Isolationsfehlers von Feuer m+1 innerhalb des Kabelabschnittes ist dann durch die Gleichung (7) gegeben:

3

$$s = \frac{x \, (R'_L + R_s)}{R_s} \, . \tag{7}$$

Die angegebenen Formeln gelten jedoch exakt nur bei gleichlangen Kabelabschnitten $I_s$ zwischen den einzelnen Feuern. Ist diese Voraussetzung nicht exakt erfüllt, so läßt sich der Fehlerort nur angenähert rechnerisch ermitteln, wobei in den Formeln ein gemittelter Wert für $R_s$ gemäß Formel (8) eingesetzt wird:

$$R_s = \frac{R_g - R_a - R_b - nR_T}{n-1} \, . \tag{8}$$

Dabei bedeutet $R_T$ den Gleichstromwiderstand der Primärwicklung des Serientransformators eines jeden Flugplatzfeuers.

Ob Formeln (1) bis (3) — Fehler in einer der Zuleitungen — oder Formeln (4) bis (8) — Fehler zwischen zwei Feuern — anzuwenden sind, hängt davon ab, ob y kleiner bzw. größer als 1 ist.

## Patentansprüche

1. Ortungsgerät für Isolationsfehler eines mehrere Flugplatzfeuer und dazwischen liegende Kabelabschnitte enthaltenden Serienstromkreises, wobei die Kabelabschnitte jeweils aus einem Innenleiter und einem diesen konzentrisch umgebenden Schirm bestehen, gekennzeichnet durch zwei Hauptklemmen (K3, K4) zum Verbinden des von seiner Speisequelle abgetrennten Serienstromkreises (SK) mit einer Wechselspannungsquelle (T1), durch einen der Wechselspannungsquelle (T1) parallelgeschalteten Vergleichszweig (V) einer Meßbrücke, durch einen ein Abgleichinstrument (M3) enthaltenden Abgleichzweig zwischen einem Abgriff (A) des Vergleichszweiges (V) und einer Hilfsklemme (K5) zum Anschluß des Schirmes (SR) der Kabelabschnitte, durch einen Spannungsmesser (M1, M2) zwischen einer der Hauptklemmen (K3, K4) und dem Abgriff (A) des Vergleichszweiges (V), und durch einen Abgleichkondensator (C) mit einstellbarer Kapazität, der einerseits mit der Hilfsklemme (K5) verbunden und andererseits mittels eines Umschalters (S6) an jede der beiden Klemmen (K1, K2) der Wechselspannungsquelle (T1) schaltbar ist.

2. Ortungsgerät nach Anspruch 1, dadurch gekennzeichnet, daß zwischen jeder der Hauptklemmen (K3, K4) und dem Abgriff (A) des Vergleichszweiges (V) der Meßbrücke ein Spannungsmesser (M1, M2) liegt.

3. Ortungsgerät nach Anspruch 2, dadurch gekennzeichnet, daß zwischen jeder der Hauptklemmen (K3, K4) und dem zugeordneten Ende des Vergleichszweiges (V) ein Eichwiderstand (R4) bzw. ein Vergleichstransformator (T2) angeordnet sind, und daß ein Umschalter (S8) vorgesehen ist, mit dem sich die beiden einerseits an den Hauptklemmen (K3, K4) liegenden Spannungsmesser (M1, M2) dem Eichwiderstand (R4) bzw. dem Vergleichstransformator (T2) parallel schalten lassen.

4. Ortungsgerät nach einem der Ansprüche 1 bis 3, dadurch gekennzeichnet, daß die Wechselspannungsquelle mit einstellbarer Spannung vorgesehen ist.

## Claims

1. A device for locating insulation defects of a series circuit which includes a plurality of airfield beacons and interposed cable sections, wherein the respective cable sections consist of an inner conductor and a screen which concentrically surrounds the inner conductor, characterised by two main terminals (K3, K4) for connecting the series circuit (SK), separated from its supply source, to an alternating voltage source (T1), by a comparison branch (V) of a measuring bridge connected parallel to the alternating voltage source (T1), by a balancing branch which includes a balancing instrument (M3) between a tap (A) of the comparison branch (V) and an auxiliary terminal (K5) connection point of the screen (SR) of the cable section, by a voltmeter (M1, M2) between one of the main terminals (K3, K3) and the tap (A) of the comparison branch (V), and by a balancing capacitor (C) which has an adjustable capacitance and which on the one hand is connected to the auxiliary terminal (K5) and on the other hand can be connected to each of the two terminals (K1, K2) of the alternating voltage source (T1) by means of a change-over switch (S6).

2. A locating device as claimed in Claim 1, characterised in that a voltmeter (M1, M2) is arranged between each of the main terminals (K3, K4) and the tap (A) of the comparison branch (V) of the measuring bridge.

3. A locating device as claimed in Claim 2, characterised in that a calibration resistor (R4) or a comparison transformer (T2), as the case may be, is arranged between each of the main terminals (K3, K4) and the assigned end of the comparison branch (V), and that there is provided a change-over switch (S8), by means of which the two voltmeters (M1, M2), which are connected to the main terminals (K3, K4) on the one hand, can be connected parallel to the calibration resistor (R4) or the comparison transformer (T2), as the case may be.

4. A locating device as claimed in one of Claims 1 to 3, characterised in that the alternating voltage source is provided with an adjustable voltage.

**Revendications**

1. Appareil de localisation de défauts d'isolement d'un circuit de courant série comportant plusieurs balises de terrain d'aviation et des sections de câble se trouvant entre elles, les sections de câble étant respectivement constituées par un conducteur intérieur et un blindage qui l'entoure concentriquement, caractérisé par deux bornes principales (K3, K4) pour relier le circuit de courant série (SK), séparé de sa source d'alimentation, à une source de tension alternative (T1), une branche de comparaison (V) d'un pont de mesure montée en parallèle sur la source de courant alternatif (T1), une branche d'équilibrage, contenant un instrument d'équilibrage (M3), entre une prise (A) de la branche de comparaison (V) et une borne auxiliaire (K5) pour le raccordement du blindage (SR) des sections de câble, un voltmère (M1, M2) entre une des bornes principales (K3, K4) et la prise (A) de la branche de comparaison (V), et un condensateur d'équilibrage (C), possédant une capacité réglable qui d'une part est relié à la borne auxiliaire (K5) et d'autre part peut être relié à chacune des deux bornes (K1, K2) de la source de tension alternative, par l'intermédiaire d'un inverseur (S6).

2. Appareil de localisation suivant la revendication 1, caractérisé par le fait qu'un voltmètre (M1, M2) est monté entre chacune des bornes principales (K3, K4) et la prise (A) de la branche de comparaison (V).

3. Appareil de localisation suivant la revendication 2, caractérisé par le fait qu'une résistance d'étalonnage (R4) ou un transformateur de comparaison (T2) sont montés entre chacune des bornes principales (K3, K4) et l'extrémité associée de la branche de comparaison (V), et qu'il est prévu un inverseur (S8) à l'aide duquel les deux voltmètres (M1, M2), qui sont reliés d'un côté aux bornes principales (K3, K4), peuvent être branchés en parallèle sur la résistance d'étalonnage (R4) ou le transformateur de comparaison (T2).

4. Appareil de localisation suivant une des revendications 1 à 3, caractérisé par le fait que la source de tension alternative est munie d'une tension réglable.